# EUROPÄISCHE PATENTSCHRIFT

(11) **EP 0 546 293 B1**
(45) Veröffentlichungstag und Bekanntmachung des Hinweises auf die Patenterteilung: **05.07.1995**
(21) Anmeldenummer: 92118239.0
(22) Anmeldetag: 24.10.1992
(51) Int. Cl.: H01J 37/34

(54) **Vorrichtung zum Beschichten eines Substrats, insbesondere mit elektrisch nichtleitenden Schichten**
Apparatus for coating a substrate, in particular for electrical insulating layers
Appareil pour revêtir un substrate, notamment pour des couches en matériau électriquement non-conducteur

(30) Priorität: 26.11.1991 DE 4138794; 19.02.1992 DE 4204998
(43) Veröffentlichungstag der Anmeldung: 16.06.1993
(73) Patentinhaber: LEYBOLD AKTIENGESELLSCHAFT, D-63450 Hanau (DE)
(72) Erfinder: Szczyrbowski, Joachim, Dr., W-8758 Goldbach (DE); Teschner, Götz, Dipl.-Ing., W-6460 Gelnhausen (DE); Bräuer, Günter, Dr., W-6463 Freigericht 2 (DE)

(56) Entgegenhaltungen:
- EP-A- 0 186 865
- DD-A- 221 202
- DD-A- 252 205
- DE-B- 1 025 234
- DE-B- 1 068 972
- US-A- 5 082 546

## Beschreibung

Die Erfindung betrifft eine Vorrichtung zum Beschichten eines Substrats, insbesondere mit elektrisch nichtleitenden Schichten von elektrisch leitfähigen Targets in reaktiver (z. B. oxidierender) Atmosphäre, bestehend aus einer Stromquelle, die mit in einer evakuierbaren Beschichtungskammer angeordneten, Magnete einschließende Kathoden verbunden ist, die elektrisch leitend an die Targets angeschlossen sind, die sich auf dem Substrat niederschlagen, wobei elektrisch voneinander und von der Sputterkammer getrennte Anoden angeordnet sind, die in einer Ebene zwischen den Kathoden und dem Substrat vorgesehen sind.

Es ist bereits eine Zerstäubungseinrichtung gemäß des Oberbegriffs des Anspruchs 1 zur Herstellung dünner Schichten bekannt (DD 252 205), bestehend aus einem Magnetsystem und mindestens zwei darüber angeordneten Elektroden aus dem zu zerstäubenden Material, wobei diese Elektroden elektrisch so gestaltet sind, daß sie wechselweise Kathode und Anode einer Gasentladung sind. Die Elektroden sind zu diesem Zwecke an eine sinusförmige Wechselspannung von vorzugweise 50 Hz angeschlossen.

Diese bekannte Zerstäubungseinrichtung soll besonders für die Abscheidung dielektrischer Schichten durch reaktive Zerstäubung geeignet sein. Durch den Betrieb der Einrichtung mit etwa 50 Hz soll vermieden werden, daß es zur Flitterbildung an der Anode und im Falle von Metallbeschichtung zu elektrischen Kurzschlüssen (sogenannten Arcs) kommt.

Bei einer anderen bereits bekannten Vorrichtung zum Aufstäuben eines dünnen Films, bei der die Geschwindigkeit des Niederbringens von Schichten unterschiedlicher Materialien regelbar ist (DE 39 12 572), um so zu extrem dünnen Schichtpaketen zu gelangen, sind mindestens zwei unterschiedliche Arten von kathodenseitig vorgesehenen Gegenelektroden angeordnet.

Weiterhin ist eine Anordnung zum Abscheiden einer Metalllegierung mit Hilfe von HF-Kathodenzerstäubung bekannt (DE 35 41 621), bei der abwechselnd zwei Targets angesteuert werden, wobei die Targets die Metallkomponenten der abzuscheidenden Metallegierung jedoch mit unterschiedlichen Anteilen enthalten. Die Substrate sind zu diesem Zweck auf einem Substratträger angeordnet, der von einer Antriebseinheit während des Zerstäubungsvorgangs in Rotation versetzt wird.

Durch eine vorveröffentlichte Druckschrift (DE 38 02 852) ist es außerdem bekannt, bei einer Einrichtung für die Beschichtung eines Substrats mit zwei Elektroden und wenigstens einem zu zerstäubenden Material das zu beschichtende Substrat zwischen den beiden Elektroden in einem räumlichen Abstand anzuordnen und die Wechselstrom-Halbwellen als niederfrequente Halbwellen mit im wesentlichen gleichen Amplituden zu wählen.

Gemäß einer anderen vorveröffentlichten Druckschrift (DE 22 43 708) ist ein Verfahren zur Erzeugung einer Glimmentladung bekannt mit einer in einem Arbeitsgas angebrachten Elektrodenanordnung, an die eine Betriebsspannung angelegt wird, wobei das Verfahren durch die Erzeugung eines Magnetfeldes, das zusammen mit der Elektrodenanordnung mindestens eine Falle zum Festhalten praktisch aller von der Elektrodenanordnung emittierten Elektronen ergibt, die eine zur Ionisierung des Arbeitsgases ausreichende Energie haben. Für dieses Verfahren findet eine Elektrodenanordnung Verwendung, bei der die Elektroden paarweise vorgesehen sind. Insbesondere beschreibt diese Druckschrift auch Hohlelektroden, in deren Innerem eine Glimmentladung erzeugbar ist, wobei die Elektroden als Rohrschalen ausgebildet sind.

Weiterhin sind ein Verfahren und eine Vorrichtung in einer älteren, nicht vorveröffentlichten Patentanmeldung beschrieben (DE 41 06 770 A1) zum reaktiven Beschichten eines Substrats mit einem elektrisch isolierenden Werkstoff, beispielsweise mit Siliziumdioxid (SiO₂) bestehend aus einer Wechselstromquelle, die mit in einer Beschichtungskammer angeordneten Magnete einschließende Kathoden verbunden ist, die mit Targets zusammenwirken, wobei zwei erdfreie Ausgänge der Wechselstromquelle mit je einer ein Target tragenden Kathode verbunden sind, wobei beide Kathoden in der Beschichtungskammer nebeneinanderliegend in einem Plasmaraum vorgesehen sind und zum gegenüberliegenden Substrat jeweils etwa den gleichen räumlichen Abstand aufweisen. Der Effektivwert der Entladespannung wird dabei von einer über eine Leitung an die Kathode angeschlossenen Spannungseffektivwerterfassung gemessen und als Gleichspannung einem Regler über eine Leitung zugeführt, der über ein Regelventil den Reaktivgasfluß vom Behälter in die Verteilerleitung so steuert, daß die gemessene Spannung mit einer Sollspannung übereinstimmt.

Schließlich ist eine Vorrichtung zum reaktiven Beschichten eines Substrats in einer älteren, nicht vorveröffentlichten Patentanmeldung beschrieben (DE 41 36 655 A1; DE 40 42 289 A1), bei der eine elektrisch von der Vakuumkammer getrennte, als Magnetronkathode ausgebildete, aus zwei elektrisch voneinander getrennten Teilen bestehende Kathode, bei der der Targetgrundkörper mit Joch und Magneten als der eine Teil - unter Zwischenschaltung einer Kapazität - an den negativen Pol einer Gleichstrom-Spannungsversorgung und das Target als der andere Teil über eine Leitung und unter Zwischenschaltung einer Drossel und einem dieser parallel liegenden Widerstand an die Stromversorgung angeschlossen ist und wobei das Target über eine weitere Kapazität mit dem Pluspol der Stromversorgung und mit der Anode verbunden ist, die ihrerseits - unter Zwischenschaltung eines Widerstands - auf Masse liegt, wobei in Reihe zur induktionsarmen Kapazität eine Induktivität in die Zweigleitung zum Widerstand und zur Drossel eingeschaltet ist und der Wert für den Widerstand typischerweise zwischen 2 KΩ und 10 KΩ liegt.

Diese ältere Vorrichtung ist bereits so ausgebildet, daß sie die überwiegende Zahl der während eines Beschichtungsprozesses auftretenden Arcs unterdrückt und die Energie der Arcs absenkt und die Wiederzündung des Plasmas nach einem Arc verbessert.

Der vorliegenden Erfindung liegt nun die Aufgabe zugrunde, die während des Beschichtungsprozesses mittels Magnetronsputterquelle in reaktiver Atmosphäre auftretenden Arcs möglichst völlig zum Verschwinden zu bringen bzw. bereits in einer Phase des Prozesses, in der die Neigung zur Bildung eines Arcs zunimmt, diese Neigung zu erkennen und ihr entgegenzuwirken. Diese Stabilisierung des Sputterprozesses soll darüber hinaus besonders unempfindlich gegenüber Wasserdampfresten im Rezipienten sein.

Insbesondere soll das Verhalten der Vorrichtung gegenüber der Neigung, Arcs zu bilden, für solche Verfahren verbessert werden, die geeignet sind zur Beschichtung von Glasscheiben von metallisch leitfähigen Targets in reaktiver (z. B. oxidierender) Atmosphäre nichtleitende Schichten abzuscheiden.

Weiterhin sollen alle Kathoden mit einem frei wählbaren Leistungsverhältnis betrieben werden können, so daß ihr Leistungspotential asymmetrisch ist.

Schließlich liegt dieser Erfindung noch die Aufgabe zugrunde, die Vorrichtung so auszubilden, daß die Besonderheiten von Anlagen besonderer Größe keinen negativen Effekt auf die Stabilität und die Zuverlässigkeit und Leistungsfähigkeit der Vorrichtung haben können.

Diese Aufgabe wird gemäß der Erfindung durch eine Vorrichtung gelöst, bei der die Ausgänge der Sekundärwicklung eines unter Zwischenschaltung einer Drosselspule mit einem Mittelfrequenzgenerator verbundenen Transformators jeweils über Versorgungsleitungen an eine der Kathoden angeschlossen sind, wobei die Versorgungsleitungen über eine erste Zweigleitung untereinander verbunden sind, in die ein Schwingkreis, vorzugsweise eine Spule, und ein Kondensator eingeschaltet sind, und wobei jede der beiden Versorgungsleitungen jeweils sowohl über ein das Gleichspannungspotential gegenüber Erde einstellendes erstes Netzwerk mit der Beschichtungskammer als auch über ein entsprechendes zweites Netzwerk mit der jeweiligen Anode verbunden sind und wobei die Verknüpfungen zwischen Spule und Versorgungsleitung und Kondensator und Versorgungsleitung über eine zweite Zweigleitung in Verbindung stehen, in die eine Gleichrichterdiode und ein Widerstand eingeschaltet sind, wobei die Kathode der Gleichrichterdiode mit der Verknüpfung zwischen der Versorgungsleitung und der parallel geschalteten Spule verbunden ist.

Gemäß der Erfindung kommt es also darauf an, die Kathoden "weich" zu zünden, was mit Hilfe einer Drossel geschehen kann, die zwischen dem Transformator und dem Mittelfrequenzgenerator eingeschaltet ist. Weiterhin ist eine Umschwinganordnung zwischen den Kathoden vorgesehen, die durch ein Arc zum Schwingen angeregt werden kann und die den Arc beim Umschwingen löscht. Die Eigenresonanz des Schwingkreises muß dabei ein Vielfaches der Arbeitsfrequenz der Anordnung sein.

Die Erfindung läßt die verschiedensten Ausführungsmöglichkeiten zu; zwei davon sind in den anliegenden Zeichnungen, die die Schaltschemata zweier Vorrichtungen zeigen, schematisch näher dargestellt.

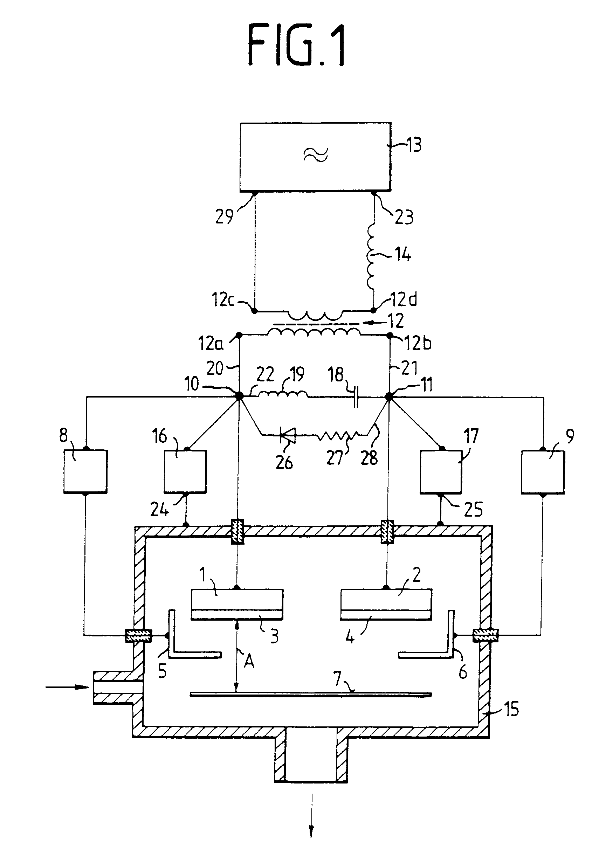

Es werden gemäß Figur 1 in der Beschichtungskammer 15 zwei Kathoden 1, 2 von dem Mittelfrequenzgenerator 13 über die beiden Versorgungsleitungen 20, 21 mit sinusförmigem Wechselstrom der Frequenz von 40 kHz so gespeist, daß die Kathoden abwechselnd den Minus- und den Pluspol der Sputterentladung darstellen.

In der Beschichtungskammer 15 sind zwei Magnetronkathoden 1, 2 so benachbart angeordnet, daß zwischen den beiden Kathoden ein Plasma gezündet werden kann. Dabei werden die Kathoden so orientiert, daß die Oberflächen der auf den Kathoden angeordneten Targets 3, 4 in einer Ebene und parallel zur Ebene des Substrats 7 liegen oder unter einem Winkel zueinander und zur Substratebene angeordnet sind.

Zwischen den Targets 3, 4 und der Substratebene wird ein Abstand A eingehalten. In diesem Zwischenraum sind die Elektroden 5, 6 angeordnet, die über die elektrischen Netzwerke 8 und 9 mit den Kathoden 1 bzw. 2 in den Punkten 10 bzw. 11 verbunden sind.

In den Verbindungspunkten 10 bzw. 11 sind die Kathoden 1 bzw. 2 außerdem mit jeweils einem Anschluß 12a bzw. 12b der Sekundärwicklung des Transformators 12 verbunden. Dieser Transformator 12 erhält seine Energie aus dem Mittelfrequenzgenerator 13, in dem eine Ausgangsklemme 23 dieses Mittelfrequenzgenerators 13 mit einem Anschluß der Drosselspule 14, die andere Ausgangsklemme 29 des Mittelfrequenzgenerators 13 mit einem Anschluß 12c der Primärwicklung des Transformators 12 und der andere Anschluß 12d der Primärwicklung des Transformators 12 mit dem zweiten Anschluß der Drosselspule 14 verbunden sind.

Die Verknüpfungspunkte 10 bzw. 11 sind außerdem noch mit den Netzwerken 16 bzw. 17 verbunden. Der zweite Anschluß 24, 25 der Netzwerke 16, 17 ist mit der Beschichtungskammer 15 verbunden. An den Verknüpfungspunkt 10 ist der eine Anschluß einer Spule 19 angeschlossen, deren zweiter Anschluß mit einem Anschluß des Kondensators 18 verbunden ist. Der zweite Anschluß des Kondensators ist mit dem Verknüpfungspunkt 11 verbunden.

Die Netzwerke 8, 9 und 16, 17 bestehen aus Reihenschaltungen von Dioden, Widerständen und Kondensatoren und stellen insgesamt das Gleichspannungspotential gegenüber der Erde (Masse) ein.

In der vorstehend beschriebenen Anordnung erzeugt der Mittelfrequenzgenerator 13 eine sinusförmige Wechselspannung, die mit dem Transformator 12 so hochgespannt wird, daß der Spannungsbereich an die Arbeitsspannung der Magnetronkathode 1, 2 angepaßt ist. Die beschriebene Schaltung Kathode 1, Transformator 12 zu Kathode 2 impliziert, daß zwischen den beiden Kathoden eine galvanische Verbindung besteht, in die über den Transformator 12 die Wechselspannung induziert wird. Durch diese Maßnahme wird erreicht, daß zu einem Zeitpunkt die Kathode 1 den Minuspol, d. h. den sputternden Teil der Entladung, und Kathode 2 den Pluspol der Entladung bilden. Zu einem anderen Zeitpunkt bildet die Kathode 1 den Pluspol der Entladung, und Kathode 2 ist der Minuspol und sputtert damit.

Die Frequenz der Mittelfrequenzspannung wird so niedrig gewählt, daß die Plasmaentladung bei jedem Nulldurchgang der Wechselspannung verlischt. Sie zündet in jeder Halbwelle der Wechselspannung neu, sobald die Spannung am Transformator 12 genügend angestiegen ist.

Dieses Wechselspiel sorgt dafür, daß die Entladung immer eine durch das Absputtern blanke Oberfläche als Pluspol findet. Wenn die eine Kathode als Pluspol dient, wird sie von der anderen in diesem Moment sputternden Kathode mit nichtleitenden Schichten belegt. Die Wechselfrequenz muß nun so hoch gewählt werden, daß die Belegung unwesentlich für den Prozeß bleibt.

Parallel der Verbindungsleitung 22 zwischen den Verknüpfungspunkten 10 und 11 bzw. den beiden Versorgungsleitungen 20, 21 ist eine zweite Verbindungsleitung 28 vorgesehen, in die eine Gleichrichterdiode 26 und ein Widerstand 27 eingeschaltet sind, und zwar derart, daß die Kathode der Gleichrichterdiode 26 mit der ersten Versorgungsleitung 20 in Verbindung steht und die Anode der Gleichrichterdiode 26 mit dem Widerstand 27, der wiederum an die zweite Versorgungsleitung 21 angebunden ist.

Durch die Diode 26 wird ein Teil der Leistung in den Widerstand 27 abgeleitet, wenn der Punkt 10 negativer ist als Punkt 11. Diese Leistung wird der Sputterkathode 1 entzogen. Nach dem Umpolen der Wechselspannung sperrt die Diode 26, und die Sputterkathode 2 sputtert mit voller Leistung.

Da der physikalische Mechanismus identisch zum Gleichspannungssputtern ist, treten natürlich auch Arcs auf. Aber die Entstehung eines Arcs ist neben den Bedingungen an der Targetoberfläche auch an Zeit, Strom- und Potentialbedingungen geknüpft (wählt man die Wechselfrequenz so hoch, daß die Polarität schon wieder wechselt, bevor sich der Arc ausbilden konnte). Die Drossel 14 bewirkt eine Verzögerung im Stromanstieg sowohl beim Zünden als auch bei der Ausbildung der Arcs. Der aus der Spule 19 und dem Kondensator 18 gebildete Schwingkreis ist auf eine Frequenz eingestellt, die wesentlich höher ist als die Arbeitsfrequenz- etwa das 50fache. Sollte sich ein Arc ausbilden, schwingt dieser Schwingkreis an und verursacht einen zusätzlichen Wechsel in der Polarität der Kathoden, so daß der Arc sofort verschwindet. Die Netzwerke 8, 9 bzw. 16, 17 sorgen dafür, daß die Potentiale der Elektroden 5, 6 und der Beschichtungskammer 15 so gehalten werden, daß geringe Feldstärken in der Kammer 15 auftreten und damit die Arc-Bildung ebenfalls verzögern.

Die praktische Arc-Freiheit wird nun durch die Kombination dieser Maßnahmen erreicht: 2 galvanisch verbundene Kathoden, Frequenz, Drossel, Netzwerke für Potentialeinstellung.
o Für die Arbeitsfrequenz wurde ein Optimum bei 40 kHz gefunden. Die Anwendung von Frequenzen abweichend von 40 kHz im Bereich von 8 kHz bis 70 kHz ist bei Hinnahme von Qualitätseinbußen denkbar.
o Statt einphasigem Wechselstrom kann eine Anordnung mit mehrphasigem (Drehstrom) Wechselstrom benutzt werden.
o Der Transformator 12 kann mit mehreren Sekundärwicklungen versehen werden, so daß mehrere Paare von Kathoden betrieben werden.
o Die Anordnung der Kathoden kann statt nebeneinander
   - ineinander geschachtelt,
   - dachförmig über dem Substrat,
   - gegenüberliegend mit durchbrochenem Substrat in der Mitte,
   - ähnlich einem Quadrupol räumlich verteilt sein.
o Es können bei gleichen Targetmaterialien auf beiden Kathoden 1, 2 unterschiedliche Verteilungen der Beschichtungsrate in der Substratebene erzeugt werden.
   Ist auf Kathode 1 ein anderes Targetmaterial aufgebracht als auf Kathode 2, so lassen sich unterschiedliche Mischungsverhältnisse in der Substratebene einstellen. Es kann sowohl die Zusammensetzung der Schicht in Abhängigkeit von ihrer Dicke geändert werden (Gradienten-Schichten) als auch die Zusammensetzung der Schichten in Abhängigkeit von der Längenausdehnung der Substrate.
o Die Konstruktionsform der verwendeten Kathoden kann neben dem Planarmagnetron auch
   - ein Zwischenpoltarget
   - ein Rohrmagnetron
   - ein Torusmagnetron
   sein.

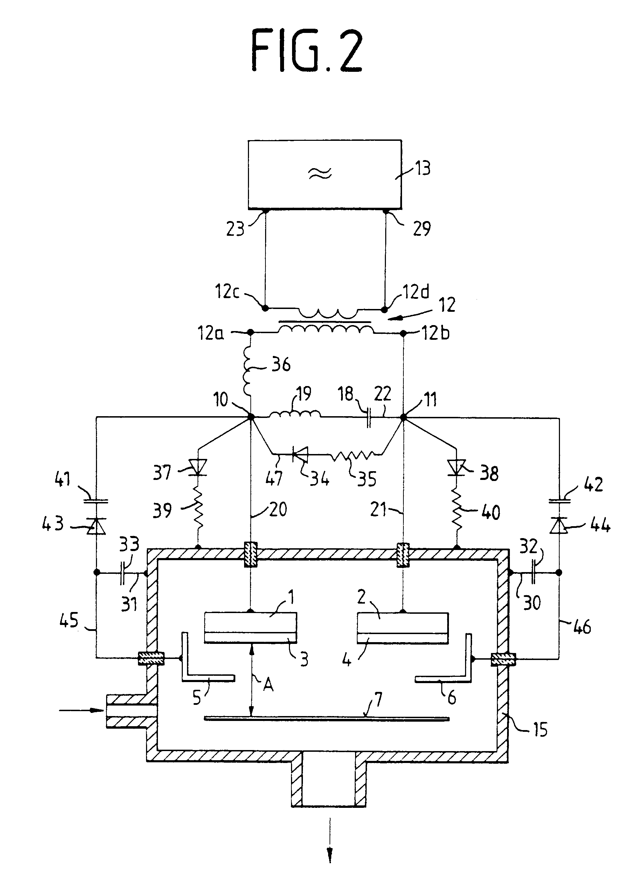

Bei dem Ausführungsbeispiel nach Figur 2 ist ebenfalls zwischen den Targets 3, 4 und der Substratebene ein Abstand A eingehalten. In diesem Zwischenraum sind die Anoden 5, 6 angeordnet, die über ein jeweils aus einem Kondensator 41 bzw. 42 und/oder einer Diode 43 bzw. 44 bestehendes elektrisches Glied mit den Kathoden 1 bzw. 2 in den Punkten 10 bzw. 11 verbunden sind.

In den Verbindungspunkten 10 bzw. 11 der Versorgungsleitungen 20, 21 sind die Kathoden 1 bzw. 2 außerdem mit jeweils einem Anschluß 12a, 12b der Sekundärwicklung des Transformators 12 verbunden, wobei in die Verbindungsleitung vom Punkt 10 zum Anschluß 12a noch eine Drosselspule 36 eingeschaltet ist. Dieser Transformator 12 erhält seine Energie aus dem Mittelfrequenzgenerator 13, in dem eine Ausgangsklemme 23 dieses Mittelfrequenzgenerators 13 mit einem Anschluß 12c der Primärwicklung des Transformators 12 und der andere Anschluß 12d der Primärwicklung des Transformators 12 mit dem zweiten Anschluß 29 des Generators 13 verbunden ist.

Die Verbindungspunkte 10 bzw. 11 sind außerdem noch an die Dioden 37 bzw. 38 angeschlossen, denen jeweils noch ein Widerstand 39 bzw. 40 nachgeschaltet ist. Die Widerstände 39 bzw. 40 sind jeweils mit der Beschichtungskammer 15 verbunden. An den Verknüpfungspunkt 10 ist der eine Anschluß einer Spule 19 angeschlossen, deren zweiter Anschluß mit einem Anschluß des Kondensators 18 verbunden ist. Der andere Anschluß des Kondensators 18 ist mit dem Verknüpfungspunkt 11 über die Zweigleitung 22 verbunden.

Die jeweils aus einem Widerstand 39 bzw. 40 und einer Diode 37 bzw. 38 gebildeten elektrischen Glieder stellen insgesamt das Gleichspannungspotential gegenüber der Erde (Masse) ein. Es sei noch erwähnt, daß die elektrischen Glieder 41, 43 bzw. 42, 44 über Zweigleitungen 30 bzw. 31, in die jeweils Kondensatoren 32, 33 eingeschaltet sind, mit der Kammer 15 verbunden sind.

Die Verknüpfungspunkte 10, 11 stehen außerdem über eine zweite Zweigleitung 47 in Verbindung, die der ersten Zweigleitung 22 parallel geschaltet ist und in die ein elektrisches Glied eingeschaltet ist, das aus einer Diode 34 und einem Widerstand 35 gebildet ist, wobei die Diode 34 so geschaltet ist, daß sie den Stromdurchgang durch die Leitung 47 vom Verknüpfungspunkt 10 zum Verknüpfungspunkt 11 sperrt.

In der vorstehend beschriebenen Anordnung erzeugt der Mittelfrequenzgenerator 13 eine sinusförmige Wechselspannung, die mit dem Transformator 12 so hochgespannt wird, daß der Spannungsbereich an die Arbeitsspannung der Magnetronkathoden 1, 2 angepaßt ist. Die beschriebene Schaltung Kathode 1, Transformator 12 zu Kathode 2 impliziert, daß zwischen den beiden Kathoden eine galvanische Verbindung besteht, in die über den Transformator 12 die Wechselspannung induziert wird. Durch diese Maßnahme wird erreicht, daß zu einem Zeitpunkt die Kathode 1 den Minuspol, d. h. den sputternden Teil der Entladung, und Kathode 2 den Pluspol der Entladung bilden. Zu einem anderen Zeitpunkt bildet die Kathode 1 den Pluspol der Entladung, und die Kathode 2 ist der Minuspol und sputtert damit.

Die Frequenz der Mittelfrequenzspannung wird so niedrig gewählt, daß die Plasmaentladung bei jedem Nulldurchgang der Wechselspannung verlischt. Sie zündet in jeder Halbwelle der Wechselspannung neu, sobald die Spannung am Transformator 12 genügend angestiegen ist.

Dieses Wechselspiel sorgt genau wie beim Ausführungsbeispiel nach Figur 1 dafür, daß die Entladung immer eine durch das Absputtern blanke Oberfläche als Pluspol findet.

Sollte sich ein Arc ausbilden, schwingt der Schwingkreis 18, 19 an und verursacht einen zusätzlichen Wechsel in der Polarität der Kathoden 1, 2, so daß der Arc sofort verschwindet. Die elektrischen Glieder 41, 43 bzw. 42, 44 sorgen dafür, daß die Potentiale der Elektroden 5, 6 und der Beschichtungskammer 15 so gehalten werden, daß geringe Feldstärken in der Kammer 15 auftreten und damit die Arc-Bildung ebenfalls verzögern. Die praktische Arc-Freiheit wird nun durch die Kombination folgender Maßnahmen erreicht: Zwei galvanisch verbundene Kathoden 1, 2, Schwingkreis 18, 19, Drossel 14, elektrische Glieder 41, 43 bzw. 42, 44 und 37, 39 bzw. 38, 40 für die Potentialeinstellung.

Die Vorteile und Arbeitsbedingungen beider vorstehend beschriebener Ausführungsformen sind im wesentlichen gleich, wobei auch bei der Ausführungsform nach Figur 2 die Anordnung der Kathoden
- ineinander geschachtelt,
- dachförmig über dem Substrat,
- gegenüberliegend mit durchbrochenem Substrat in der Mitte,
- ähnlich einem Quadrupol räumlich verteilt sein.

Die Konstruktionsform der verwendeten Kathoden kann neben dem Planarmagnetron auch
- ein Zwischenpoltarget
- ein Rohrmagnetron
- ein Torusmagnetron

sein.

### Bezugszeichenliste

- 1: Kathode
- 2: Kathode
- 3: Target
- 4: Target
- 5: Anode, Elektrode
- 6: Anode, Elektrode
- 7: Substrat
- 8: elektrisches Netzwerk
- 9: elektrisches Netzwerk
- 10: Verbindungspunkt, Verknüpfungspunkt
- 11: Verbindungspunkt, Verknüpfungspunkt
- 12: Transformator
- 12a, 12b: Anschlußklemmen
- 12c, 12d: Anschlußklemmen
- 13: Mittelfrequenzgenerator
- 14: Drosselspule
- 15: Beschichtungskammer
- 16: Netzwerk
- 17: Netzwerk
- 18: Kondensator
- 19: Spule
- 20: erste Versorgungsleitung
- 21: zweite Versorgungsleitung
- 22: erste Zweigleitung
- 23: Ausgangsklemme
- 24: Anschluß
- 25: Anschluß
- 26: Gleichrichterdiode
- 27: Widerstand
- 28: zweite Zweigleitung
- 29: Ausgangsklemme
- 30: Zweigleitung
- 31: Zweigleitung
- 32: Kondensator
- 33: Kondensator
- 34: Diode
- 35: Widerstand, Spule
- 36: Widerstand, Spule
- 37: Kondensator
- 38: Kondensator
- 39: Widerstand
- 40: Widerstand
- 41: Kondensator
- 42: Kondensator
- 43: Diode
- 44: Diode
- 45: Zweigleitung
- 46: Zweigleitung
- 47: Verbindungsleitung

## Patentansprüche

1. Vorrichtung zum Beschichten eines Substrats (7), insbesondere mit nichtleitenden Schichten, von elektrisch leitfähigen Targets (3, 4) in reaktiver (z.B. oxidierender) Atmosphäre, bestehend aus einer Stromquelle (12, 13, 14), die mit in einer evakuierbaren Beschichtungskammer (15) angeordneten, Magnete einschließende Kathoden (1, 2) verbunden ist, die elektrisch leitend mit den Targets (3, 4) in Verbindung stehen, die zerstäubt werden und deren abgestäubte Teilchen sich auf dem Substrat (7) niederschlagen, wobei elektrisch voneinander und von der Sputterkammer (15) getrennte Anoden (5, 6) angeordnet sind, die in einer Ebene zwischen den Kathoden (1, 2) und dem Substrat (7) vorgesehen sind, **dadurch gekennzeichnet,** daß die beiden Ausgänge (12a, 12b) der Sekundärwicklung eines - unter Zwischenschaltung einer Drosselspule (14) - mit einem Mittelfrequenzgenerator (13) verbundenen Transformators (12) jeweils an eine Kathode (1 bzw. 2) über zwei Versorgungsleitungen (20, 21) angeschlossen sind, wobei die erste und die zweite Versorgungsleitung (20, 21) über eine erste Zweigleitung (22) untereinander in Verbindung stehen, in die ein Schwingkreis, vorzugsweise eine Spule (19), und ein Kondensator (18) eingeschaltet sind, und wobei jede der beiden Versorgungsleitungen (20, 21) jeweils sowohl über ein das Gleichspannungspotential gegenüber Erde einstellendes erstes Netzwerk (16 bzw. 17) mit der Beschichtungskammer (15) als auch über ein entsprechendes zweites Netzwerk (8 bzw. 9) mit der jeweiligen Anode (5 bzw. 6) verbunden sind, wobei die Verknüpfung (10) zwischen Spule (19) und erster Versorgungsleitung (20) mit der Kathode einer Gleichrichterdiode (26) verbunden ist, während die Anode der Gleichrichterdiode (26) - unter Zwischenschaltung eines Widerstands (27) - an die Verknüpfung (11) zwischen dem Kondensator (18) und der zweiten Versorgungsleitung (21) angebunden ist, weshalb die beiden Kathoden (1, 2) mit einem frei wählbaren Leistungsverhältnis betreibbar sind.

2. Vorrichtung zum Beschichten eines Substrats (7) nach Anspruch 1, **dadurch gekennzeichnet,** daß die beiden Ausgänge (12a, 12b) der Sekundärwicklung eines mit einem Mittelfrequenzgenerator (13) verbundenen Transformators (12) jeweils an eine Kathode (1 bzw. 2) über zwei Versorgungsleitungen (20, 21) angeschlossen sind, wobei die erste und die zweite Versorgungsleitung (20, 21) über zwei parallele Zweigleitungen (22, 47) untereinander in Verbindung stehen und in die erste Zweigleitung (22) ein Schwingkreis, vorzugsweise eine Spule (19) und ein Kondensator (18), eingeschaltet sind und wobei jede der beiden Versorgungsleitungen (20, 21) jeweils sowohl über ein das Gleichspannungspotential gegenüber Erde einstellendes erstes elektrisches Glied (37, 39 bzw. 38, 40) mit der Beschichtungskammer (15) als auch über ein entsprechendes zweites elektrisches Glied (41, 43 bzw. 42, 44) mit der jeweiligen Anode (5 bzw. 6) verbunden sind, wobei die Verknüpfung (10) zwischen der Spule (19) und der in die erste Versorgungsleitung (20) eingeschalteten Drossel (36) mit der Kathode einer Gleichrichterdiode (34) verbunden ist, während die Anode dieser Gleichrichterdiode (34) unter Zwischenschaltung eines Widerstands (35) an die Verknüpfung (11) zwischen dem Kondensator (18) des Schwingkreises und der zweiten Versorgungsleitung (21) angebunden ist, weshalb die beiden Kathoden (1, 2) mit einem frei wählbaren Leistungsverhältnis betreibbar sind.

3. Vorrichtung zum Beschichten eines Substrats (7) nach Anspruch 2 **dadurch gekennzeichnet,** daß die in die beiden Zweigleitungen, die die Versorgungsleitungen (20, 21) mit der Beschichtungskammer (15) verbinden, eingeschalteten ersten elektrischen Glieder jeweils aus einem Widerstand (39 bzw. 40) und einer Diode (37 bzw. 38) gebildet sind, wobei in die die Versorgungsleitungen (20 bzw. 21) mit der Anode (5 bzw. 6) verbindenden Zweigleitungen (45 bzw. 46) jeweils ein zweites elektrisches Glied (41, 43 bzw. 42 44) eingeschaltet ist, daß jeweils aus einem Kondensator (41 bzw. 42) oder einem Kondensator (41 bzw. 42) und einer Diode (43 bzw. 44) gebildet ist.

4. Vorrichtung zum Beschichten eines Substrats (7) nach den Ansprüchen 2 und 3, **dadurch gekennzeichnet,** daß an jede die Versorgungsleitung (20 bzw. 21) mit der jeweiligen Anode (5 bzw. 6) verbindende Zweigleitung (45 bzw. 46) eine zweite Zweigleitung (30 bzw. 31) angeschlossen ist, in die ein Kondensator (32 bzw. 33) eingeschaltet ist und die mit der Beschichtungskammer (15) in Verbindung steht, wobei die jeweilige zweite Zweigleitung (30 bzw. 31) jeweils mit dem Leitungsabschnitt verbunden ist, der von der Diode (43 bzw. 44) oder dem Kondensator (41 bzw. 42) zur Anode (5 bzw. 6) führt.

## Claims

1. Apparatus for coating a substrate (7), in particular with insulating layers, by electrically conductive targets (3, 4) in a reactive (e.g. oxidising) atmosphere, consisting of a current source (12, 13, 14) connected to cathodes (1, 2), which include magnets, are disposed in an evacuatable coating chamber (15), and are connected electrically conductively to the targets (3, 4), which are nebulised and whose nebulised particles are deposited on the substrate (7), wherein anodes (5, 6) which are electrically separate from one another and from the sputtering chamber (15) are provided in one plane between the cathodes (1, 2) and the substrate (7), characterised in that the two outputs (12a, 12b) of the secondary winding of a transformer (12) connected to a middle frequency generator (13), with an inductance coil (14) interposed, are each connected to a cathode (1 or 2) via two supply lines (20, 21), wherein the first and the second supply line (20, 21) communicate with one another via a first branch line (22), into which a resonant circuit, preferably a coil (19), and a capacitor (18) are connected, and wherein each of the two supply lines (20, 21) is connected both to the coating chamber (15) via a first mains (16 and 17 respectively) which sets the direct voltage potential relative to earth, and to the respective anode (5 or 6) via a corresponding second mains (8 or 9), wherein the link (10) between the coil (19) and the first supply line (20) is connected to a cathode of a rectifier diode (26), whilst the anode of the rectifier diode (26) is connected to the link (11) between the capacitor (18) and the second supply line (21), with a resistance (27) interposed, whereby the two cathodes (1, 2) can be operated at a freely selectable output ratio.

2. Apparatus for coating a substrate (7) according to claim 1, characterised in that the two outputs (12a, 12b) of the secondary winding of a transformer (12) connected to a middle frequency generator (13) are each connected to a cathode (1 or 2) via two supply lines (20, 21), wherein the first and the second supply line (20, 21) communicate with one another via two parallel branch lines (22, 47), and a resonant circuit, preferably a coil (19) and a capacitor (18), are connected into the first branch line (22), and wherein each of the two supply lines (20, 21) is connected both to the coating chamber (15) via a first electrical member (37, 39 and 38, 40 respectively) which sets the direct voltage potential relative to earth, and to the respective anode (5 or 6) via a corresponding second electrical member (41, 43 and 42, 44 respectively), wherein the link (10) between the coil (19) and the choke (36) connected into the first supply line (20) is connected to the cathode of a rectifier diode (34), whilst the anode of the rectifier diode (34) is connected to the link (11) between the capacitor (18) of the resonant circuit and the second supply line (21), with a resistance (35) interposed, whereby the two cathodes (1, 2) can be operated at a freely selectable output ratio.

3. Apparatus for coating a substrate (7) according to claim 2, characterised in that the first electrical members connected into the two branch lines connecting the supply lines (20, 21) to the coating chamber (15) each consist of a resistance (39 and 40 respectively) and a diode (37 and 38 respectively), wherein a respective second electrical member (41, 43 and 42, 44 respectively) is connected into the branch lines (45 and 46 respectively) connecting the supply lines (20 and 21 respectively) to the anode (5 and 6 respectively) and is formed in each case of a capacitor (41 and 42 respectively) or of a capacitor (41 and 42 respectively) and a diode (43 and 44 respectively).

4. Apparatus for coating a substrate (7) according to claims 2 and 3, characterised in that a second branch line (30 and 31 respectively), into which a capacitor (32 and 33 respectively) is connected and which communicates with the coating chamber (15), is connected to the branch line (45 and 46 respectively) connecting the supply line (20 and 21 respectively) to the respective anode (5 or 6), the respective second branch line (30 and 31 respectively) in each case being connected to the line section leading from the diode (43 and 44 respectively) or the capacitor (41 and 42 respectively) to the anode (5 and 6 respectively).

## Revendications

1. Dispositif pour revêtir un substrat (7), en particulier avec des couches non conductrices de cibles électriquement conductrices (3, 4) dans une atmosphère réactive (par exemple oxydante), consistant en une source de courant (12, 13, 14) qui est reliée à des cathodes (1, 2) comprenant des aimants, disposées dans une chambre de revêtement (15) qui peut être mise sous vide, et qui sont reliées de manière électriquement conductrice aux cibles (3, 4) qui sont vaporisées et dont les particules détachées par vaporisation se déposent sur le substrat (7), dans lequel sont disposées des anodes (5, 6) électriquement séparées l'une de l'autre et de la chambre de pulvérisation (5) qui sont prévues dans un plan entre les cathodes (1, 2) et le substrat (7), caractérisé en ce que les deux sorties (12a, 12b) de l'enroulement secondaire d'un transformateur (12) relié à un générateur moyenne fréquence (13) avec interposition d'une bobine de choc (14) sont reliées chacune à une cathode (1 ou 2) par l'intermédiaire de deux lignes d'alimentation (20, 21), la première et la seconde lignes d'alimentation (20, 21) étant reliées entre elles par une première dérivation (22) dans laquelle est branché un circuit oscillant, de préférence une bobine (19) et un condensateur (18), et chacune des deux lignes d'alimentation (20, 21) étant reliée à la chambre de revêtement (15) par l'intermédiaire d'un premier réseau (16 ou 17) établissant le potentiel à tension continue par rapport à la terre et également à l'anode (5 ou 6) correspondante par l'intermédiaire d'un second réseau (8 ou 9) correspondant, la jonction (10) entre la bobine (19) et la première ligne d'alimentation (20) étant reliée à la cathode d'une diode redresseuse (26), tandis que l'anode de la diode redresseuse (26) est reliée à la jonction (11) entre le condensateur (18) et la seconde ligne d'alimentation (21) avec interposition d'une résistance (27), de sorte que les deux cathodes (1, 2) peuvent être excitées avec un rapport de puissance qui peut être choisi librement.

2. Dispositif pour revêtir un substrat (7) selon la revendication 1, caractérisé en ce que les deux sorties (12a, 12b) de l'enroulement secondaire d'un transformateur (12) relié à un générateur moyenne fréquence (13) sont reliées chacune à une cathode (1 ou 2) par deux lignes d'alimentation (20, 21), la première et la seconde lignes d'alimentation (20, 21) étant reliées entre elles par deux dérivations parallèles (22, 47) et un circuit oscillant, de préférence une bobine (19) et un condensateur (18), étant branché dans la première dérivation (22), et chacune des deux lignes d'alimentation (20, 21) étant reliée à la chambre de revêtement (15) par l'intermédiaire d'un premier organe électrique (37, 39 ou 38, 40) qui établit le potentiel en tension continue par rapport à la terre et aussi à l'anode (5 ou 6) correspondante par l'intermédiaire d'un second organe électrique (41, 43 ou 42, 44) correspondant, la jonction (10) entre la bobine (19) et la bobine de choc (36) branchée dans la première ligne d'alimentation (20) étant reliée à la cathode d'une diode redresseuse (34), tandis que l'anode de cette diode redresseuse (34) est reliée à la jonction (11) entre le condensateur (18) du circuit oscillant et la seconde ligne d'alimentation (21) avec interposition d'une résistance (35), de sorte que les deux cathodes (1, 2) peuvent être excitées avec un rapport de puissance qui peut être choisi librement.

3. Dispositif pour revêtir un substrat (7) selon la revendication 2, caractérisé en ce que les premiers organes électriques branchés dans les deux dérivations qui relient les lignes d'alimentation (20, 21) à la chambre de revêtement (15) sont constitués chacun par une résistance (39 ou 40) et par une diode (37 ou 38), un second organe électrique (41, 43 ou 42, 44) qui est constitué par un condensateur (41 ou 42) ou par un condensateur (41 ou 42) et par une diode (43 ou 44) étant branché dans chacune des dérivations (45 ou 46) qui relient les lignes d'alimentation (20 ou 21) à l'anode (5 ou 6).

4. Dispositif pour revêtir un substrat (7) selon les revendications 2 et 3, caractérisé en ce qu'une seconde dérivation (30, 31) dans laquelle est branché un condensateur (32 ou 33) et qui est reliée à la chambre de revêtement (15) est reliée à chaque dérivation (45 ou 46) qui relie la ligne d'alimentation (20 ou 21) à l'anode (5 ou 6) correspondante, chaque seconde dérivation (30 ou 31) étant reliée à la section de ligne qui conduit de la diode (43 ou 44) ou du condensateur (41 ou 42) à l'anode (5 ou 6).
